(19) Europäisches Patentamt
European Patent Office
Office européen des brevets

(11) **EP 3 705 901 A1**

(12) **EUROPEAN PATENT APPLICATION**

(43) Date of publication:
**09.09.2020 Bulletin 2020/37**

(51) Int Cl.:
***G01R 33/00*** *(2006.01)* ***G01R 33/07*** *(2006.01)*

(21) Application number: **20156319.4**

(22) Date of filing: **10.02.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.03.2019 SI 201900051**

(71) Applicant: **Univerza v Ljubljani Fakulteta za elektrotehniko**
**1000 Ljubljana (SI)**

(72) Inventors:
• **Trontelj, Janez**
**1000 Ljubljana (SI)**
• **Gradisek, Miha**
**1236 Trzin (SI)**
• **Bercan, Damjan**
**1275 Smartno pri Litiji (SI)**
• **Sesek, Aleksander**
**1234 Menges (SI)**

(74) Representative: **Jersan, Tatjana**
**ITEM d.o.o.**
**Patent and Trademark Agency**
**Resljeva cesta 16**
**1000 Ljubljana (SI)**

(54) **A MAGNETIC SENSOR, WHICH INCLUDES A GENERATION OF A TEST DYNAMIC MAGNETIC FIELD**

(57) The present invention relates to a magnetic sensor comprising two or more Hall elements arranged in a particular spatial configuration with respect to a particular application (e.g. measurement of linear displacement or angular displacement) with an associated electronic circuit controlling the Hall elements that measures the relevant parameters on individual Hall elements, which enables the calibration of the entire magnetic sensor depending on the characterization results, and to a new method of characterization of such a magnetic sensor. Each Hall element has an integrated micro coil. The integrated micro coils simulate the movement of a constant magnetic field source along the entire path, allowing us to characterize the individual Hall elements and the entire magnetic sensor, including the associated electronic circuit, in a faster and easier way.

Figure 2

EP 3 705 901 A1

## Description

The present invention relates to a sensor for magnetic field measurement, which is mainly used for measuring linear displacement or angular displacement, to which testing coils are integrated that have a corresponding circuit for generating a test dynamic magnetic field which, in the characterization phase of the sensor, mimics the field of a moving external magnet. The present invention makes it possible to considerably simplify the methods of characterization of magnetic sensors known to date.

## Prior art

Sensors based on the use of a magnetic field are present in many contactless measuring applications in harsh operating conditions. Magnetic sensors of this type may be constructed on the basis of one or more Hall elements and associated circuit. Hall elements represent an optimal choice between performance and cost, but such sensors must be characterized before use, especially from the standpoint of sensitivity of an individual Hall element, of possible asymmetries within the sensor that vary between sensors as a result of process variations during sensor production. Depending on the characterization results, the sensitivity and symmetry of the entire magnetic sensor can be adjusted to the desired value by calibrating the sensitivity of an individual Hall element in the associated magnetic sensor circuit.

There are some known processes for characterizing magnetic sensors based on Hall elements. One of the first processes is based on the excitation of a test sensor with an external DC magnetic field via a Helmholtz coil, but it is a relatively time-consuming and expensive approach to mass production. When characterizing the field of Hall elements, a suitable test configuration must be applied that provides a test magnetic field across all elements. Another characterization process is based on the resistance measurement of a Hall element as described in US7492178B2. The advantage of this process is that no extra external or internal magnetic field source is needed, as a response of the sensor for a given sensor bias current is measured. The accuracy of characterization in this process depends on determining the exact correlation between the sensitivity and resistance of the individual Hall element, which depends on the concentration of doping of the material in the Hall element, and on the geometry of the sensor, which is not an ideal parameter due to production variations. The characterization of a sensor can also be performed via an internally generated magnetic field using a micro coil that generates a reference magnetic field disclosed in EP0655628A2. The hitherto known approaches using a micro coil have been used to characterize a single Hall element or a field of Hall elements via a common response of all elements.

## Description of invention

The present invention relates to a magnetic sensor comprising two or more Hall elements arranged in a particular spatial configuration with respect to a particular application (e.g. measurement of linear displacement or angular displacement) with an associated electronic circuit controlling the Hall elements that measures the relevant parameters on individual Hall elements, which enables the calibration of the entire magnetic sensor depending on the characterization results, and to a new method of characterization of such a magnetic sensor.

The invention will be described hereinbelow by way of embodiments and illustrated on the drawings, in which:

Figure 1 shows a relationship between a phase shift of the excitation magnetic field of micro coils T as a function of the position of the associated Hall element H on path L

Figure 2 shows an embodiment with eight Hall elements arranged in a circular path L to measure angular displacement

Figure 3 shows an embodiment with eight Hall elements arranged in a linear path L to measure linear displacement

Figure 4 shows an embodiment with sixteen Hall elements arranged in a linear path L' and a circular path L"

Figure 5 shows four control current signals via micro coils

Figure 6 shows the processed sine and cosine signals from the captured responses of Hall elements to a dynamic magnetic field

Figure 7 shows a distorted and corrected angle of rotation of the magnetic field

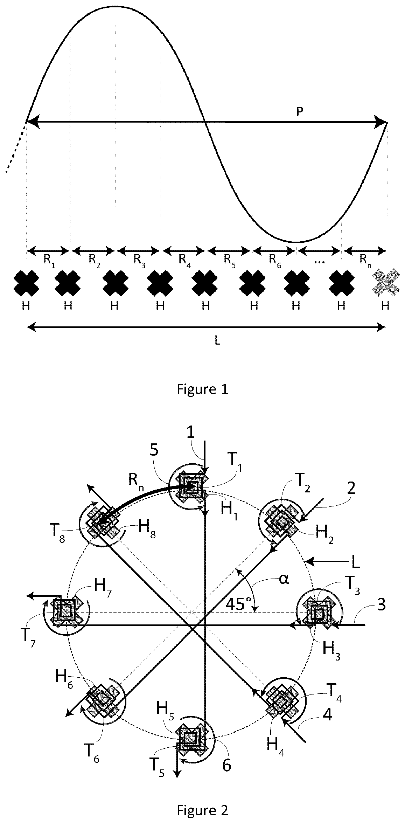

A magnetic sensor used to measure displacement within a given path L includes two or more Hall elements H ($H_1$, $H_2$, ...) spatially distributed along a given path L with a mutual distance $R_n$ ($R_1$, $R_2$, ...) along the path L, wherein

the distances $R_n$ also include the distance of the first Hall element H from the beginning of path L or the last Hall element H from the end of path L in the case where the first Hall element H does not coincide with the beginning of path L, or the last Hall element H with the end of path L, so that the sum of all distances $R_n$ is equal to path L (Figure 1), and the Hall elements H are adapted to measure changes in the magnetic field due to the movement of the constant magnetic field of magnetic poles north-south arranged along path L, wherein each of said Hall elements H has a micro coil T ($T_1$, $T_2$, ...) integrated within the magnetic sensor to generate the magnetic field during the characterization process, and an electronic circuit adapted to control said Hall elements H, to measure the voltage responses of said Hall elements H as a result of changing the magnetic field due to movement of the magnetic field source, and to calibrate the entire magnetic sensor based on the characterization results. The electronic circuit is also adapted to excite micro coils T during the characterization process and simultaneously to measure the voltage of Hall elements H. The individual micro-coil T is excited by sinusoidal function with period P. The magnetic fields on the individual micro coils T are in such mutual phase shifts that they correspond to the mutual distance $R_n$, with the entire period P corresponding to the entire path L.

It is desirable that the magnetic field generated by the micro coils T in the region of the associated Hall element H be as homogeneous as possible, so the axis of an individual micro coil T is preferably aligned with the axis of the associated Hall element H.

The method for characterizing a magnetic sensor includes the following steps:

1) resetting/switching on the magnetic sensor including Hall elements H,
2) exciting a magnetic field in sine function with period P by the electronic circuit on each individual micro coil T, whereby the generated magnetic fields on the individual micro coils T are in such mutual phase shifts that they correspond to the mutual distance $R_n$, with the entire period P corresponding to the entire path L;
3) simultaneously to the second step, the electronic circuit measures the parameters on said Hall elements H, resulting in the characterization of the individual Hall elements H and the entire sensor,
4) repeating steps 3 to 4 for any number of periods P depending on the desired measurement reliability.

The advantage of the invention lies in the fact that the integrated micro coils T eliminate the need for an external moving source of a constant magnetic field during the characterization phase. The integrated micro coils T that are excited as shown simulate the movement of a constant magnetic field source along the entire path L, allowing us to characterize the individual Hall elements H and the entire magnetic sensor, including the associated electronic circuit, in a faster and easier way. As a result, the characterization and calibration of the magnetic sensor can be performed immediately after its production without the need for an external moving source of a constant magnetic field.

In the case where two Hall elements H are arranged along the path L at a distance of L/2, there is a phase shift P/2 between the two magnetic fields on the associated micro coils T, so that the associated micro coils T can be controlled by the same current, yet in the opposite direction.

**First embodiment with eight Hall elements arranged in a circular path L to measure angular displacement**

Figure 2 illustrates one of the possible paths L, namely a circumference. The approach with a circumference can be integrated in applications where the angle of rotation in the axis of the measured object is measured. The presented circular configuration consists of eight Hall elements $H_1$-$H_8$ with corresponding micro coils $T_1$-$T_8$ equidistantly arranged along the circular path L with mutual distances $R_n$. Said delayed magnetic field approach mimics the moving external magnetic field of a diametrically magnetized magnet located in an axis above the sensor. Individual pairs of a Hall element and a micro coil, starting with a Hall element $H_1$ and the corresponding micro coil $T_1$, are shifted by an angle $\alpha$, which is 45° in this embodiment, since this angle is equal to the total angle 360° divided by the number of Hall elements, which in this case is eight. Each single micro coil $T_1$-$T_8$ is excited by phase-shifted alternating currents 1, 2, 3 and 4, the phase-shift angle corresponding to the solid angle $\alpha$ of an individual micro coil $T_1$-$T_8$ in the integrated circuit. Due to the symmetry, the distance between the opposite Hall elements $H_1$ and $H_5$ is L/2, as a result a magnetic field with a phase shift of P/2 (or for $\pi$) is generated on the associated coils $T_1$ and $T_5$, so that the control current 1 which generates a magnetic field 5 via a micro coil $T_1$ can also be used to generate a magnetic field 6 of reverse polarity in the opposite coil $T_5$ with inverted contacts. Remaining control currents: current 2 flowing through $T_2$ and $T_6$, current 3 flowing through $T_3$ and $T_7$, and current 4 flowing through $T_4$ and $T_8$ are used according to the same principle, wherein the phase shift P/2 (or $\pi$) is present between the magnetic fields in said coil pairs.

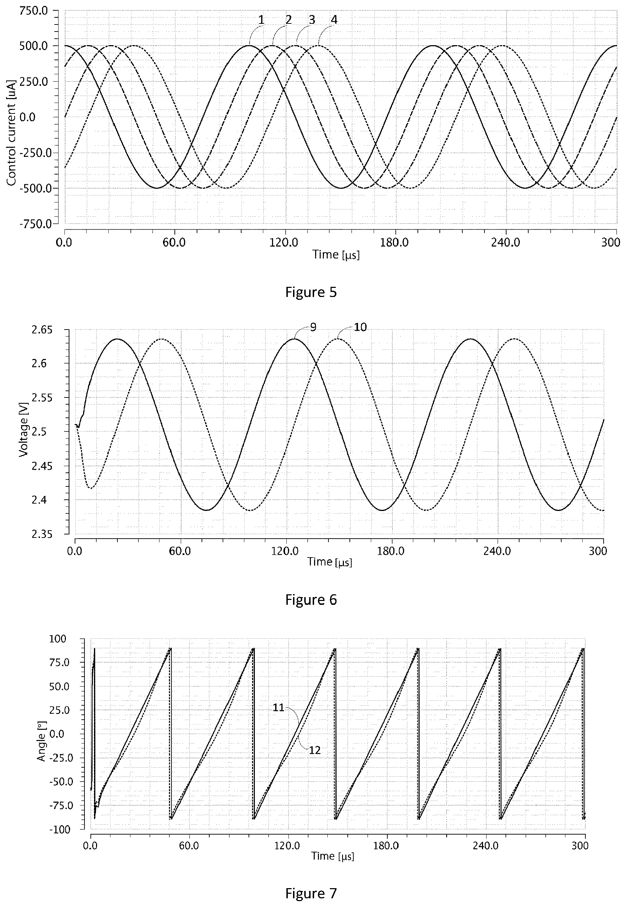

The described approach with the four control currents shown in Figure 5 (1, 2, 3, 4) for the eight micro coils $T_1$-$T_8$ is adjacent as it halves the number of control signals.

The response of an individual Hall element $H_1$-$H_8$ to a magnetic field depends on its position on the path L. The opposed Hall elements $H_1$ and $H_5$ detect a magnetic field of opposite polarity 5 and 6, which is comparable to the response to a permanent external magnet. Given the signal processing of all responses of Hall elements $H_1$-$H_8$, illustrated by Equations 1, 2, and 3, signal processing returns by $\pi/4$ mutually delayed signals 10 and 9 (Fig. 6) representing the sine and cosine of the angle $\alpha$. A further algorithm uses arctg to determine an angle 11 which is the angle $\alpha$ and repeats from -90° to +90°. If there are non-idealities of Hall sensors, they are identified during the characterization process as they are reflected as a nonlinear time course of the angle shown in Figure 7 as the dashed line 12. These non-idealities are corrected through programming during the calibration phase to achieve a linear course of the angle as a function of time, shown as line 11 in Figure 7, which is not an object of the present invention.

$$Sin(\alpha) = H_1 + H_2 + H_3 + H_4 - H_5 - H_6 - H_7 - H_8 \qquad (1)$$

$$Cos(\alpha) = H_3 + H_4 + H_5 + H_6 - H_7 - H_8 - H_1 - H_2 \qquad (2)$$

$$\alpha = \tan^{-1}\frac{\sin(\alpha)}{\cos(\alpha)} \qquad (3)$$

**Second embodiment with eight Hall elements arranged in a linear path L to measure linear displacement**

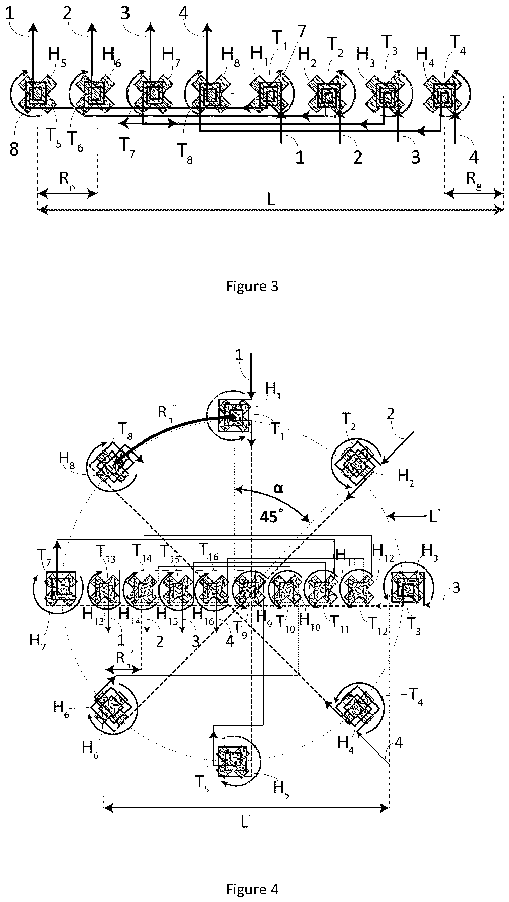

A second embodiment illustrated in Figure 3 describes a sensor in a linear configuration where the path L is a line segment and is used in applications where the linear displacement of a desired object is measured. Along the path L, eight Hall elements $H_1$-$H_8$ with corresponding micro coils $T_1$-$T_8$ are arranged at equal distances $R_n$ ($R_1$ to $R_7$), wherein in this embodiment the distance Rg between the last Hall element $H_4$ and the end of the measured path L is equal to other distances $R_n$. Each of the micro coils $T_1$-$T_8$ is excited by a phase-shifted alternate operating current 1, 2, 3, and 4, which is used to generate the magnetic field. Through the micro coils $T_1$ and $T_5$, which are spaced apart by half a period, current 1 flows in the opposite direction, thus generating magnetic fields 7 and 8 of opposite polarities measured by the Hall elements $H_1$ and $H_5$. Among all control currents 1, 2, 3 and 4, the phase shifts are equivalent to the distances between individual micro coils $T_1$-$T_8$, with the total period P (360°) being equivalent to the total length of the measured path L. Using the equations 1, 2, 3 and 4, the signal processing returns the measured displacement d, where the distance L represents the entire measured path that, if a permanent external magnet were used, would be equal to the distance between the beginning and end of one north-south pair of the permanent external magnet.

$$d = \frac{\alpha * L}{360°} \qquad (4)$$

**Third embodiment of a system of two magnetic sensors, each having eight Hall elements arranged in a linear path L' and a circular path L"**

The embodiment of a circular and linear magnetic sensor integrated on one integrated circuit is shown in Figure 4. The system consists of two magnetic sensors each having eight pairs of a Hall element and corresponding micro coil. The integration of two magnetic sensors on one integrated circuit allows for a separate use in applications of measurement of angle of rotation or measurement of linear displacement. The advantage of the approach is a smaller area of the two magnetic sensors, with the path L' being linear and integrated inside the path L", which is circular in shape. On the linear path L', the Hall elements $H_9$-$H_{16}$ and the corresponding micro coils $T_9$-$T_{16}$ are arranged at equal mutual distances $R'_n$. The first Hall element $H_{13}$ coincides with the beginning of the linear path L', the mutual distances $R'_n$ between the adjacent Hall elements $H_9$ to $H_{16}$ are identical and at the same time identical to the distance $R'_n$ between the last Hall element $H_{12}$ and the end of the linear path L'. On the circular path L", the Hall elements $H_1$-$H_8$ and the corresponding micro coils $T_1$-$T_8$ are arranged at equal mutual distances $R"_n$. Consequently, the eight pairs of a Hall element and a micro coil on the circular path L" are mutually shifted by a spatial angle $\alpha$ of 45°. This system allows us to simultaneously carry out characterization and calibration of both magnetic sensors. A further advantage is that only four control signals 1, 2, 3 and 4 are needed to generate sixteen test magnetic fields on the coils, said signals being connected through the contacts in a way that each of the two configurations functions in the same way as presented in embodiments 1 and 2. Each of the control lines 1, 2, 3, 4 is connected through two opposite micro coils in a circular configuration and through two micro coils in a linear configuration.

**EP 3 705 901 A1**

**Claims**

1. A magnetic sensor including generation of a test dynamic magnetic field for the application in the measurement of displacement within a path (L), comprising:

   - two or more Hall elements (H) spatially distributed along a given path (L) with a mutual distance ($R_n$) along the path (L), wherein the mutual distances ($R_n$) also include the distance of the first Hall element (H) from the beginning of path (L) or the last Hall element (H) from the end of path (L) in the case where the first one does not coincide with the beginning of path (L), or the last one with the end of path (L), the sum of all distances ($R_n$) being equal to path (L), and the Hall elements (H) are adapted to measure changes in the magnetic field due to the movement of the constant magnetic field with the magnetic poles north-south,
   - an electronic circuit provided to control said Hall elements (H), to measure the voltage responses of said Hall elements (H) as a result of changing the magnetic field due to movement of the magnetic field source, and to calibrate the entire magnetic sensor based on the characterization results,

   **characterized in**

   - **that** each of said Hall elements (H) has a micro coil (T) integrated within the magnetic sensor for generating the magnetic field during the characterization process,
   - **that** said electronic circuit is also adapted for excitation of said micro coils (T) during the characterization process and simultaneously for measuring the voltage of Hall elements (H),
   - **that** an individual micro-coil (T) is excited by sinusoidal function with period (P),
   - **that** the magnetic fields on the individual micro coils (T) are in such mutual phase shifts that they correspond to the mutual distance ($R_n$), wherein the entire period (P) corresponding to the entire path (L).

2. The magnetic sensor as claimed in claim 1, **characterized in that** the axis of an individual micro coil (T) is aligned with the axis of the corresponding Hall element (H).

3. The magnetic sensor as claimed in claims 1 to 2, **characterized by** comprising at least two Hall elements (H) with corresponding micro coils (T) that are arranged along the path (L) at a distance of (L/2), wherein there is a phase shift (P/2) between the two magnetic fields on the associated micro coils (T), and the corresponding micro coils (T) are controlled by the same current, yet in the opposite direction.

4. The magnetic sensor as claimed in claims 1 to 3, **characterized in that** the Hall elements (H) are arranged in space along a certain path (L) at mutual distances ($R_n$) in a circular configuration or a linear configuration.

5. The magnetic sensor as claimed in claims 1 to 4, **characterized in that** eight Hall elements ($H_1$-$H_8$) with corresponding micro coils ($T_1$-$T_8$) are arranged at equal mutual distances ($R_n$) in a circular configuration along the path (L) in the form of a circumference, wherein individual pairs of a Hall element and a micro coil are offset by a spatial angle $\alpha$, which is 45°.

6. The magnetic sensor as claimed in claims 1 to 4, **characterized in that** eight Hall elements ($H_1$-$H_8$) with corresponding micro coils ($T_1$-$T_8$) are arranged at equal distances ($R_n$) in a linear configuration along the path (L) which is a line segment, wherein the first Hall element ($H_5$) coincides with the beginning of the path (L), the mutual distances ($R_1$ to $R_7$) between the adjacent Hall elements ($H_1$ to $H_8$) are identical and at the same time identical to the distance ($R_8$) between the last Hall element ($H_4$) and the end of the path (L).

7. A system comprising two magnetic sensors as claimed in claims 1 to 6, **characterized in that** the first magnetic sensor has eight Hall elements ($H_9$-$H_{16}$) with corresponding micro coils ($T_9$ to $T_{16}$) arranged at equal mutual distances ($R'_n$) along the path (L') which is a line segment, that the second magnetic sensor has eight Hall elements ($H_1$ to $H_8$) with corresponding micro coils ($T_1$ to $T_8$) arranged at equal mutual distances ($R''_n$) along the path (L") in the form of a circumference, wherein the path (L') is integrated within the path (L") and wherein the first Hall element ($H_{13}$) coincides with the beginning of the path (L'), the mutual distances ($R'_n$) between the adjacent Hall elements ($H_9$ to $H_{16}$) are identical and at the same time identical to the distance ($R'_n$) between the last Hall element ($H_{12}$) and the end of the path (L').

8. A method for characterizing a magnetic sensor as claimed in claims 1 to 6 and a system as claimed in claim 7, wherein the micro coils (T) simulate the movement of a constant magnetic field source along the entire path (L), **characterized by** including the following steps:

1) resetting/switching on the magnetic sensor including Hall elements (H);

2) exciting a magnetic field in sine function with period P by the electronic circuit on each individual micro coil T, whereby the generated magnetic fields on the individual micro coils T are in such mutual phase shifts that they correspond to the mutual distance $R_n$, with the entire period P corresponding to the entire path L;

3) measuring, simultaneously to the second step, the parameters on said Hall elements H by the electronic circuit, resulting in the characterization of the individual Hall elements H and the entire sensor,

4) repeating steps 3 to 4 for any number of periods (P) depending on the desired measurement reliability.

Figure 1

Figure 2

Figure 3

Figure 4

Figure 5

Figure 6

Figure 7

Europäisches
Patentamt

European
Patent Office

Office européen
des brevets

# EUROPEAN SEARCH REPORT

Application Number

EP 20 15 6319

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 367 067 A1 (MELEXIS TECH SA [CH]) 29 August 2018 (2018-08-29) * paragraphs [0068], [0080] - [0092]; figures 1-5 * | 1-8 | INV.<br>G01R33/00<br>G01R33/07 |
| A | JP 2015 169517 A (ASAHI KASEI DENSHI KK) 28 September 2015 (2015-09-28) * paragraphs [0002], [0007], [0017] - [0023]; figures 1-3 * | 1-8 | |
| A | US 7 358 880 B1 (MELANSON JOHN L [US]) 15 April 2008 (2008-04-15) * the whole document * | 1-8 | |

TECHNICAL FIELDS
SEARCHED      (IPC)

G01R
G01D
H02K

The present search report has been drawn up for all claims

| Place of search | Date of completion of the search | Examiner |
|---|---|---|
| Munich | 24 July 2020 | Philipp, Peter |

## ANNEX TO THE EUROPEAN SEARCH REPORT
## ON EUROPEAN PATENT APPLICATION NO.

EP 20 15 6319

This annex lists the patent family members relating to the patent documents cited in the above-mentioned European search report.
The members are as contained in the European Patent Office EDP file on
The European Patent Office is in no way liable for these particulars which are merely given for the purpose of information.

24-07-2020

| Patent document cited in search report | | | Publication date | Patent family member(s) | | | Publication date |
|---|---|---|---|---|---|---|---|
| EP 3367067 | A1 | | 29-08-2018 | CN<br>EP<br>US | 108507594<br>3367067<br>2018245948 | A<br>A1<br>A1 | 07-09-2018<br>29-08-2018<br>30-08-2018 |
| JP 2015169517 | A | | 28-09-2015 | JP<br>JP | 6265419<br>2015169517 | B2<br>A | 24-01-2018<br>28-09-2015 |
| US 7358880 | B1 | | 15-04-2008 | CN<br>EP<br>US<br>WO | 101611326<br>2109779<br>7358880<br>2008098067 | A<br>A1<br>B1<br>A1 | 23-12-2009<br>21-10-2009<br>15-04-2008<br>14-08-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7492178 B2
- EP 0655628 A2